# EUROPEAN PATENT SPECIFICATION

(11) **EP 2 672 321 B1**
(45) Date of publication and mention of the grant of the patent: **18.03.2015**
(21) Application number: 13170539.4
(22) Date of filing: 04.06.2013
(51) Int. Cl.: G03F 7/20

(54) **Device for positioning a waferchuck**
Vorrichtung zur Positionierung einer Trägerplatte
Dispositif pour positionner un porte-substrat

(30) Priority: 04.06.2012 NL 2008934; 04.06.2012 NL 2008935
(43) Date of publication of application: 11.12.2013
(73) Proprietor: MI-Partners BV, 5652 AM Eindhoven (NL)
(72) Inventor: Laro, Dick, 4814 VG Breda (NL); Sanders, Leonardus Cornelis Maria, 5507RN Veldhoven (NL); Boots, Elwin, 1017RB Amsterdam (NL)
(74) Representative: Verhees, Godefridus Josephus Maria

(56) References cited:
- JP-A- H02 262 091
- US-A1- 2005 030 503
- "Magnetic gravity compensator with integrated Lorentz actuator and flux steering permanent magnet poles", RESEARCH DISCLOSURE, MASON PUBLICATIONS, HAMPSHIRE, GB, vol. 557, no. 18, 1 September 2010 (2010-09-01), page 870, XP007140028, ISSN: 0374-4353

## Description

### Field of the invention

The invention relates to a positioning device for a wafer chuck, comprising:
- a base,
- a support present on the base,
- a housing present on the support, in which there is under-pressure and which has a bottom,
- a wafer chuck displaceable over the bottom in the housing and equipped with permanent magnets, and
- positioning means for positioning the wafer chuck and located underneath the bottom, which positioning means comprise at least six actuators for positioning the wafer chuck in six directions corresponding to six degrees of freedom, where from these actuators three vertical actuators position the wafer chuck in vertical direction and around two mutually perpendicular horizontal axes, and three horizontal actuators position the wafer chuck in two mutually perpendicular horizontal directions and around the vertical axis.
- which vertical actuators each include gravity compensation means which comprise a disc-shaped round permanent magnet, as well as a coil and an annular permanent magnet having an opening in the middle, which annular magnet and which disc-shaped magnet are vertically polarized and the annular magnet is oppositely magnetized to the disc-shaped magnet,
   where: the inner diameter of the coil is larger than the outer diameter of the disc-shaped magnet, the outer diameter of the annular magnet is smaller than the outer diameter of the coil, and the inner diameter of the annular magnet is smaller than the inner diameter of the coil.

### State of the art

A positioning device of this type is known from US 2005/030503 A. Since in this known positioning device the wafer chuck is present in a vacuum space separated from the positioning means, no fouling of the wafer chuck can occur that can be ascribed to the positioning device.

### Summary of the invention

It is an object of the invention to provide a positioning device of the type defined in the opening paragraph having improved positioning means. For this purpose the positioning device according to the invention is characterized in that:
- the coil is present partially around the disc-shaped round permanent magnet and partially present above it, such that the bottom of the coil is present at a level between the bottom and top of the disc-shaped magnet, the annular permanent magnet is present in the wafer chuck above the coil, and
- the outer diameter of the annular magnet is larger than the inner diameter of the coil.

With this configuration a vertical actuation force can be exerted on the wafer chuck which within limits (within approximately 5 mm from the middle position) is independent of the vertical distance from the wafer chuck to the positioning means.

It should be observed that this configuration can also be used for other applications than for positioning a wafer chuck and in other devices than a positioning device.

The positioning means are preferably located in a closed space where there is under-pressure. The under-pressure in this space may be smaller than that in the space the wafer chuck is located in. The electronics of the positioning means are screened from the environment such that there is less chance of disturbance by environmental influences.

The positioning device further preferably comprises a slide present underneath the bottom and displaceable over the base, as well as displacement means present on the base for displacing the slide, where the positioning means are present for positioning the wafer chuck on the slide and for positioning the wafer chuck relative to the slide. As a result, the wafer chuck can be positioned accurately over a larger horizontal distance. The long stroke need not be very accurate then and can be realized with known conventional displacement means. The required accuracy is obtained by the short stroke positioning means. Furthermore, air turbulence caused by the movement of the slide cannot affect the position of the wafer chuck. Preferably also the slide with displacement means is located in the closed space where under-pressure prevails.

Furthermore, the wafer chuck preferably does not accommodate coils. In consequence, no cables leading to the wafer chuck are needed, so that the height of the wafer chuck can be kept small. The wafer chuck only accommodates permanent magnets.

Above the opening in the annular magnet or underneath the disc-shaped magnet there is preferably present a further disc-shaped magnet which is also vertically polarized, where the polarization is opposite to that of the annular magnet or equal to that of the disc-shaped magnet respectively. This improves the operation of the actuator.

An embodiment of the positioning device according to the invention is characterized in that:
- the horizontal actuators each comprise two elongated, annular coils,
- an array of permanent magnets is present in the wafer chuck above each coil, which arrays extend in longitudinal direction of the coils, where:
   - above the elongated parts of the windings the magnets are vertically polarized where above one of the parts the north pole is situated at the top and above the other part the north pole is situated at the bottom,
   - above the cores of the coils where there are no windings, the magnets are horizontally polarized, where the north poles are situated on the side of those magnets where the north pole is situated at the bottom, and where
   - the coils and the permanent magnets above them are each other's mirror images.

With the configuration according to this embodiment a horizontal actuation force can be exerted on the wafer chuck which, within limits (within approximately 5 mm from the middle position) is independent of the position in the horizontal plane of the wafer chuck relative to the positioning means.

It should be observed that this embodiment can also be applied to a positioning device in which the vertical actuators and the permanent magnet present above the coil of the vertical actuators have a different design from the one described above, so that this configuration of the horizontal actuators having an array of permanent magnets above each coil, can also be applied to a positioning device according to the opening paragraph and having said six actuators, but without the above embodiment of the vertical actuators.

Between the two arrays of magnets there is preferably present a partition wall of non-magnetic material to avoid demagnetization of the permanent magnets and to enable the use of relatively small magnets which increases rigidity.

Furthermore, the two coils are preferably connected such that the magnitude of the current passing through each coil is the same.

### Brief description of the drawings

The invention will now be described in more detail below based on an example of embodiment of the positioning device according to the invention while reference is made to the appended drawing figures, in which:
Fig. 1 shows a schematic diagram of the positioning device according to the invention;
Fig. 2 shows a sectional view of a vertical actuator of the positioning device;
Fig. 3 shows a sectional view of a horizontal actuator of the positioning device;
Fig. 4 shows a bottom view of the wafer chuck; and
Fig. 5 shows a top view of the control system of the positioning means.

### Detailed description of the drawings

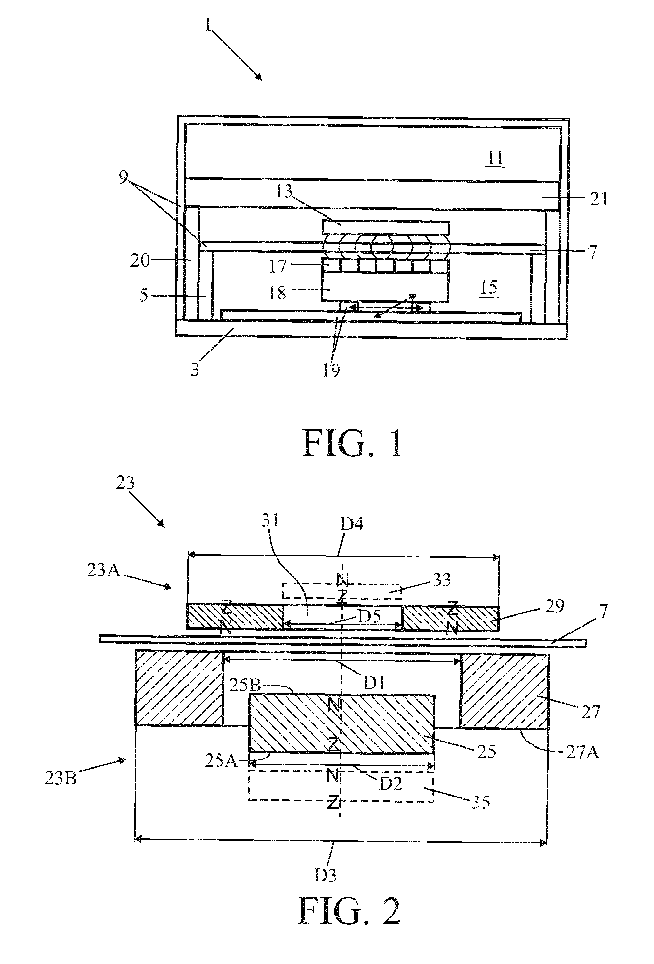

Fig. 1 shows a schematic diagram of an embodiment of the positioning device according to the invention. The positioning device 1 comprises a base 3 which accommodates a support 5. On top of the support there is the bottom 7 of a housing 9 which shuts off a space 11 in which there is under-pressure. In this space is present a wafer chuck 13 which can be displaced over the housing bottom. Underneath the bottom there is another space 15 shut off from the environment in which positioning means 17 are located for positioning the wafer chuck. These positioning means are located on a slide 18 present underneath the bottom 7 and displaceable over the base 3. The slide may also be equipped with a bottom support, for example in the form of a plurality of bearing-mounted balls.

Underneath the slide there are displacement means 19 for displacing the slide. These displacement means are formed by an endless belt present on the base and to which a sub-frame is attached and a further endless belt present on the sub-frame to which the slide is attached and which extends perpendicularly to the other belt. The sub-frame can be displaced along a guide present on the base and the slide can be displaced along a further guide present on the sub-frame. In the space 15 between the base and the bottom an under-pressure prevails as well, but this is less than the under-pressure prevailing in the space 11.

Furthermore, the base 3 accommodates a further support 20 which carries a measuring plate 21 which is situated in the space 11 above the wafer chuck 13. Measuring means for determining the position of the wafer chuck are present on the measuring plate. The advantage of this is that the position of the wafer chuck is measured directly relative to the base and not indirectly via the slide.

The positioning device comprises eight actuators (six actuators will do, but by using eight actuators control can be executed in a simpler manner). From these eight actuators there are four vertical actuators and four horizontal actuators. The actuators are designed such that they can exert a force in one direction only. The actuators consist each of two parts. One part is located in the wafer chuck and has only one or more permanent magnets and no coils or electromagnets. The other part is located on the slide and has a coil and optionally one or more further permanent magnets.

Fig. 2 shows one of the vertical actuators 23. This actuator consists of two parts, one part 23A located above the bottom 7 and the other part 23B located underneath the bottom.

The part 23B comprises a disc-shaped round permanent magnet 25 as well as a coil 27 partly around it and partly above it. The bottom 27A of the coil is located, seen in vertical direction, between the bottom 25A and top 25B of the disc-shaped magnet, and the inner diameter D1 of the coil is larger than the outer diameter D2 of the disc-shaped magnet.

The part 23A comprises an annular permanent magnet 29 having an opening 31 in the middle. This magnet 29 is located in the wafer chuck and is present above the coil 27. The outer diameter D4 of the annular magnet 29 is larger than the inner diameter D1 of the coil 27 and smaller than the outer diameter D3 of the coil, and the inner diameter D5 of the annular magnet is smaller than the inner diameter D1 of the coil.

The annular magnet 29 and the disc-shaped magnet 25 are both vertically polarized whereas the polarization of one magnet is opposite to that of the other.

Above the opening 31 in the annular magnet 29 or underneath the disc-shaped magnet 25 there may optionally be present a further disc-shaped magnet 33, 35 (indicated by broken lines) for improvement of the actuator. This further disc-shaped magnet is also vertically polarized. In the case where the further magnet 33 is used, the polarization of this further magnet is opposite to that of the annular magnet 29. In the case where the further magnet 35 is used, the polarization of this further magnet 35 is equal to that of the disc-shaped magnet.

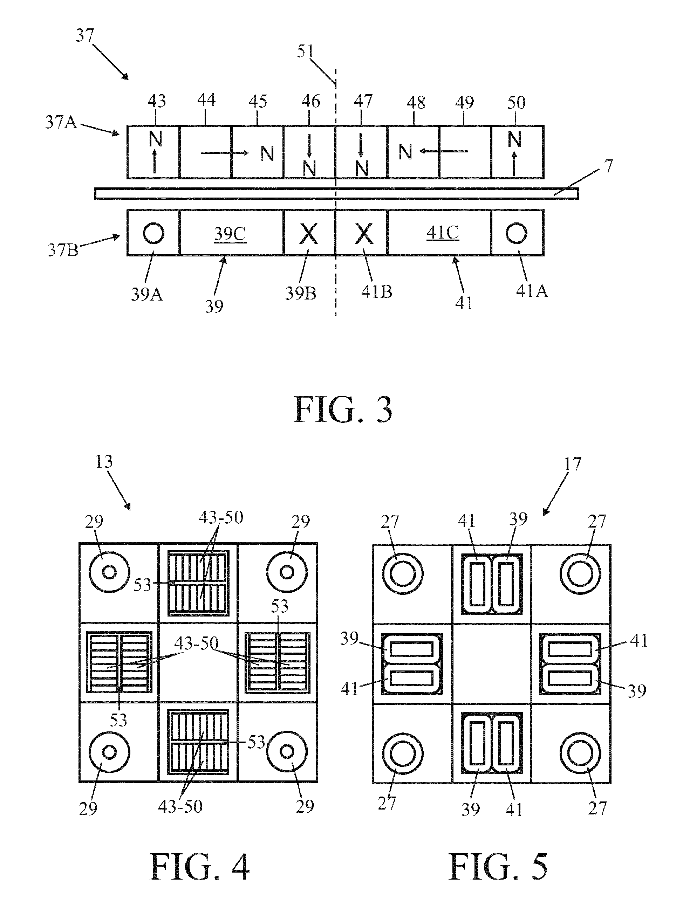

Fig. 3 shows one of the horizontal actuators 37. The actuators are based on a generally known Halbach array comprising at least five permanent magnets. This actuator too consists of two parts, one part 37A is present above the bottom 7 and the other part 37B is present underneath the bottom.

The part 37B comprises two elongated, annular coils 39 and 41 which are connected such (for example connected in series) that the magnitude of the current passing through each coil is the same.

The part 37A comprises two arrays of permanent magnets having a polarization corresponding to a Halbach array. In lieu of having five magnets in each array, each array comprises eight magnets 43 - 50 where three middle pairs of magnets 44 and 45, 46 and 47, 48 and 49 have the same polarization. By utilizing eight magnets, all magnets can have the same dimensions as a result of which they can be manufactured in a more cost-effective way.

Each array is present above one of the coils and extends in longitudinal direction of the coil. Above the elongated parts 39A, 39B and 41A, 41B of the windings, the magnets 43, 46, 47 and 50 are vertically polarized, while above one of the parts 39A, 41A the north pole N is situated at the top and above the other part 39B, 41B the north pole N is situated at the bottom. Above the cores 39C, 41C of the coils where there are no windings, the magnets 44, 45 and 48, 49 are horizontally polarized, where the north pole is situated at the magnet where the north pole is situated at the bottom.

The coils 39, 41 and the permanent magnets 43 - 50 present above them are mirror images of each other in imaginary plane 51.

For illustrative purposes Fig. 4 shows a bottom view of the wafer chuck 13 and Fig. 5 shows a top view of the control system of the positioning means 17. In these drawing figures the positions of the permanent magnets 29 and 43 - 50 and of the coils 27 and 39, 41 are clearly visible. They also show that between the two arrays of magnets 43 - 50 of the horizontal actuators a partition wall 53 of non-magnetic material is present.

Albeit the invention has been described in the foregoing based on the drawings, it should be observed that the invention is not by any manner or means restricted to the embodiment shown in the drawings. The invention is defined by the claims.

## Claims

1. A positioning device (1) for a wafer chuck, comprising:
- a base (3),
- a support (5) present on the base,
- a housing (9) present on the support, in which there is under-pressure and which has a bottom (7),
- a wafer chuck (13) displaceable over the bottom in the housing and equipped with permanent magnets (29, 43 - 50), and
- positioning means (17) for positioning the wafer chuck and located underneath the bottom, which positioning means comprise at least six actuators (23, 37) for positioning the wafer chuck (13) in six directions corresponding to six degrees of freedom, where from these actuators three vertical actuators (23) position the wafer chuck in vertical direction and around two mutually perpendicular horizontal axes, and three horizontal actuators (37) position the wafer chuck in two mutually perpendicular horizontal directions and around the vertical axis,
- which vertical actuators (23) each include gravity compensation means which comprise a disc-shaped round permanent magnet (25), as well as a coil (27) and an annular permanent magnet (29) having an opening in the middle, which annular magnet (29) and which disc-shaped magnet (25) are vertically polarized and the annular magnet is oppositely magnetized to the disc-shaped magnet,
where: the inner diameter (D1) of the coil is larger than the outer diameter (D2) of the disc-shaped magnet (25), the outer diameter (D4) of the annular magnet (29) is smaller than the outer diameter (D3) of the coil, and the inner diameter (D5) of the annular magnet (29) is smaller than the inner diameter (D1) of the coil, **characterized in that**:
- the coil (27) is present partially around the disc-shaped round permanent magnet (25) and partially present above it, such that the bottom (27A) of the coil is present at a level between the bottom and top (25A, 25B) of the disc-shaped magnet (25), the annular permanent magnet (29) is present in the wafer chuck (13) above the coil, and the outer diameter (D4) of the annular magnet (29) is larger than the inner diameter (D1) of the coil.

2. A positioning device (1) as claimed in claim 1, **characterized in that** the positioning device further comprises a slide (18) present underneath the bottom (7) and displaceable over the base (3), as well as displacement means (19) present on the base for displacing the slide, where the positioning means (17) are present for positioning the wafer chuck on the slide and for positioning the wafer chuck relative to the slide.

3. A positioning device (1) as claimed in claim 1 or 2, **characterized in that** the wafer chuck (13) does not accommodate coils.

4. A positioning device (1) as claimed in claim 1, 2 or 3, **characterized in that** above the opening (31) in the annular magnet (29) a further disc-shaped magnet (33) is present which is also vertically polarized, where the polarization is opposite to that of the annular magnet.

5. A positioning device (1) as claimed in claim 1, 2 or 3, **characterized in that** underneath the disc-shaped magnet (25) a further disc-shaped magnet (35) is present which is also vertically polarized, where the polarization is equal to that of the disc-shaped magnet.

6. A positioning device (1) as claimed in any one of the preceding claims, **characterized in that**:
- the horizontal actuators (37) each comprise two elongated, annular coils (39, 41),
- an array of permanent magnets (43 - 50) is present in the wafer chuck above each coil, which arrays extend in longitudinal direction of the coils, where:
- above the elongated parts (39A, 39B, 41A, 41B) of the windings the magnets (43, 46, 47, 50) are vertically polarized where above one of the parts (39A, 41A) the north pole is situated at the top and above the other part (39B, 41B) the north pole is situated at the bottom,
- above the cores (39B, 41B) of the coils where there are no windings, the magnets (44, 45, 48, 49) are horizontally polarized, where the north poles are situated on the side of those magnets (46, 47) where the north pole is situated at the bottom, and where
- the coils (39, 41) and the permanent magnets (43 - 50) above them are each other's mirror images.

7. A positioning device (1) as claimed in claim 6, **characterized in that** between the two arrays of magnets (43 - 50) a partition wall (53) of non-magnetic material is present.

8. A positioning device (1) as claimed in claim 6 or 7, **characterized in that** the two coils (39, 41) are connected such that the magnitude of the current passing through each coil is the same.

## Patentansprüche

1. Positionierornichtung (1) für eine Waferspannvorrichtung, umfassend:
- eine Basis (3),
- einen Träger (5) anwesend auf der Basis,
- ein Gehäuse (9) anwesend auf dem Träger, in welchem unter-Druck herscht und der einen Boden (7) aufweist,
- einen über den Boden in das Gehäuse beweglichen Waferspannvorrichtung (13), der mit Permanentmagneten (29, 43 bis 50) ausgestattet ist, und
- Positionierungsmittel (17) zum Positionieren der Waferspannvorrichtung und anwesend unterhalb des Bodens, welche Positionierungsmittel mindestens sechs Aktuatoren (23, 37) aufweisen zum Positionieren der Wafespannvorrichtung (13) in sechs Richtungen entsprechend sechs Freiheitsgraden, wobei von diese Aktuatoren drei vertikale Aktuatoren (23) die Waferspannvorrichtung in vertikaler Richtung und um zwei zueinander senkrechte horizontale Achsen positionieren, und drei horizontale Aktuatoren (37) die Waferspannvorrichtung in zwei zueinander senkrechten horizontalen Richtungen und um die vertikale Achse positionieren,
- die vertikalen Aktuatoren (23) weisen jeweils Schwerkraft-Kompensationsmittel auf, die eine scheibenförmige runde Permanentmagneten (25) umfassen, sowie eine Spule (27) und einen ringförmigen Permanentmagneten (29) mit einer Öffnung in der Mitte, wobei die ringförmige Magnet (29) und die scheibenförmigen Magneten (25) vertikal polarisiert sind und der Ringmagnet entgegengesetzt zu den scheibenförmigen Magneten magnetisiert ist,
- wobei der Innendurchmesser (D1) der Spule größer ist als der Außendurchmesser (D2) des scheibenförmigen Magneten, der Außendurchmesser (D4) des ringförmigen Magneten kleiner als der Außendurchmesser (D3) der Spule, und der innere Durchmesser (D5) des Ringmagneten kleiner ist als der Innendurchmesser (D1) der Spule,
**dadurch gekennzeichnet, dass**:
- die Spule (27) teilweise um den vorliegenden scheibenförmigen runden Permanentmagneten (25) und teilweise darüber anwesend ist, so dass der Boden (27A) der Spule auf einem Niveau zwischen der Unterseite und Obersete (25A, 25B) des scheibenförmigen Magneten vorhanden ist, wobei der ringförmige Permanentmagnet (29) in der Waferspannvorrichtung (13) über der Spule vorhanden ist, und der Außendurchmesser (D4) des ringförmigen Magneten größer ist als der Innendurchmesser (D1) des Spulen.

2. Positioniervorrichtung (1) nach Anspruch 1, **dadurch gekennzeichnet, dass** die Positioniervorrichtung ferner einen Schieber (18) aufweist der unter dem Boden (7) vorhanden ist und verschiebbar über dem Boden (3) ist, sowie Verschiebemittel (19) aufweist die auf der Basis anwesend sind zum Verschieben des Schiebers, wobei die Positionierungsmittel (17) zum Positionieren der Waferspannvorrichtung auf dem Schieber und zum Positionieren der Waferspannvorrichtung relativ zum Schlitten vorhanden sind.

3. Positioniervorrichtung (1) nach Anspruch 1 oder 2, **dadurch gekennzeichnet, dass** die Waferspannvorrichtung (13) keine Spulen aufnehmt.

4. Positioniervorrichtung (1) nach Anspruch 1, 2 oder 3, **dadurch gekennzeichnet, daß** oberhalb der Öffnung (31) in dem ringförmigen Magneten (29) einem weiteren scheibenförmigen Magneten (33) vorhanden ist, die ebenfalls vertikal polarisiert ist, wo die Polarisation entgegengesetzt ist zu derjenigen des ringförmigen Magneten.

5. Positioniervorrichtung (1) nach Anspruch 1, 2 oder 3, **dadurch gekennzeichnet, daß** unterhalb des scheibenförmigen Magneten (25) einem weiteren scheibenförmigen Magneten (35) vorhanden ist, die ebenfalls vertikal polarisiert ist, wobei die Polarisations gleich dem des scheibenförmigen Magneten ist.

6. Eine Positioniervorrichtung (1) nach einem der vorhergehenden Ansprüche, **dadurch gekennzeichnet, daß**:
- die horizontalen Aktuatoren (37) jeweils zwei langgestreckte, ringförmige Spulen (39, 41) aufweisen,
- eine Anordnung von Permanentmagneten (43 bis 50) in der Waferspannvorrichtung über jeder Spule anwesend ist, die Anordnungen erstrecken sich in Längsrichtung der Spulen, wobei:
- oberhalb der langgestreckte Teile (39A, 39B, 41A, 41B) der Windungen die Magnete (43, 46, 47, 50) vertikal polarisiert sind in dem oberhalb einer der Teile (39A, 41A) der Nordpol an der Oberseite anwesend ist und oberhalb dem anderen Teil (39B, 41B) der Nordpol unten anwesend ist,
- über die Kerne (39b, 41b) der Spulen wo es keine Wicklungen gibt, die Magnete (44, 45, 48, 49) horizontal polarisiert sind, wobei die Nordpole sich auf der Seite dieser Magnete befinden (46, 47) wobei der Nordpol sich am Boden befindet, und wobei
- die Spulen (39, 41) und die Permanentmagnete (43 bis 50) über ihnen sind gegenseitig spiegelbildlich.

7. Eine Positioniervorrichtung (1) nach Anspruch 6, **dadurch gekennzeichnet, dass** zwischen den zwei Magnetanordnungen (43 bis 50) eine Trennwand (53) aus nichtmagnetischem Material vorhanden ist.

8. Eine Positioniervorrichtung (1) nach Anspruch 6 oder 7, **dadurch gekennzeichnet, daß** die beiden Spulen (39, 41) derart verbunden sind, daß die Größe des Stroms, der durch jede Spule gehr die gleiche ist.

## Revendications

1. Dispositif de positionnement (1) pour un mandrin de plaquette, comprenant:
- une base (3),
- un support (5) présente sur la base,
- un boîtier (9) présente sur le support, dans lequel il est sous-pression et qui présente un fond (7),
- un mandrin de plaquette (13) déplaçable sur le fond dans le boîtier et muni d'aimants permanents (29, 43-50), et
- des moyens de positionnement (17) pour positionner la pince de serrage de plaquette et située en dessous du fond, lesquels moyens de positionnement comprennent au moins six actionneurs (23, 37) pour positionner le mandrin de plaquette (13) dans six directions correspondant aux six degrés de liberté, où à partir de ces actionneurs trois actionneurs verticaux (23) Positionner le support de tranche dans le sens vertical et autour de deux axes horizontaux perpendiculaires entre elles, et trois actionneurs horizontaux (37) positionner le mandrin de plaquette dans deux directions horizontales perpendiculaires et autour de l'axe vertical,
- qui actionneurs verticaux (23) comprennent chacun gravité des moyens de compensation qui comprennent un aimant permanent ronde en forme de disque (25), ainsi que d'une bobine (27) et un aimant permanent annulaire (29) ayant une ouverture au milieu, qui annulaire aimant en forme de disque magnétique (29) et qui (25) est polarisée verticalement et l'aimant annulaire est magnétisé à l'opposé de l'aimant en forme de disque,
- lorsque le diamètre intérieur (D1) de la bobine est plus grand que le diamètre extérieur (D2) de l'aimant en forme de disque, le diamètre extérieur (D4) de l'aimant annulaire est plus petit que le diamètre extérieur (D3) de la bobine, et le diamètre intérieur (D5) de l'aimant annulaire est plus petit que le diamètre intérieur (D1) de la bobine,
**caractérisé en ce que**:
- la bobine (27) est présent partiellement autour de la tour aimant permanent en forme de disque (25) et partiellement présent au-dessus, de telle sorte que le fond (27A) de la bobine est présent à un niveau compris entre la partie supérieure et inférieure (25A, 25B) de l'aimant en forme de disque de l'aimant permanent annulaire (29) est présent dans le mandrin de plaquette (13) au-dessus de la bobine, et le diamètre extérieur (D4) de l'aimant annulaire est plus grand que le diamètre intérieur (D1) de la bobine.

2. Dispositif de positionnement (1) selon la revendication 1, **caractérisé en ce que** le dispositif de positionnement comprend en outre un coulisseau (18) présente en dessous du fond (7) et pouvant être déplacé au-dessus de la base (3), ainsi que des moyens de déplacement (19) présente sur la base pour déplacer le coulisseau, dans lequel les moyens de positionnement (17) sont présents pour positionner le mandrin de plaquette sur le coulisseau et destiné à positionner la plaquette mandrin par rapport au coulisseau.

3. Dispositif de positionnement (1) selon la revendication 1 ou 2, **caractérisé en ce que** la plaquette mandrin (13) ne peut pas accueillir bobines.

4. Dispositif de positionnement (1) selon la revendication 1, 2 ou 3, **caractérisé en ce qu'**au-dessus de l'ouverture (31) dans l'aimant annulaire (29) un autre aimant en forme de disque (33) est présent qui est également polarisée verticalement, où la polarisation est opposée à celle de l'aimant annulaire.

5. Dispositif de positionnement (1) selon la revendication 1, 2 ou 3, **caractérisé en ce qu** 'au-dessous de l'aimant en forme de disque (25) en outre un aimant en forme de disque (35) est présent qui est également polarisée verticalement, où la polarisation est égale à celle de l'aimant en forme de disque.

6. Dispositif de positionnement (1) selon l'une quelconque des revendications précédentes, **caractérisé en ce que**:
- les actionneurs horizontaux (37) comprennent chacun deux bobines allongées, annulaires (39, 41),
- un ensemble d'aimants permanents (43 à 50) est présent dans le support de tranche au-dessus de chaque bobine, qui se étendent matrices dans la direction longitudinale des bobines, où:
- au-dessus des parties allongées (39a, 39b, 41a, 41b) des enroulements les aimants (43, 46, 47, 50) sont polarisées verticalement au-dessus de laquelle une des parties (39A, 41A) du pôle nord se trouve en haut et au-dessus de l'autre partie (39B, 41B) le pôle nord se trouve en bas,
- les noyaux ci-dessus (39b, 41b) des bobines où il n'y a pas de bobinages, les aimants (44, 45, 48, 49) sont à polarisation horizontale, où les pôles nord sont situés sur le côté de ces aimants (46, 47) où le pôle nord se trouve en bas, et où
- les bobines (39, 41) et les aimants permanents (43 à 50) au-dessus les uns des autres sont des images en miroir.

7. Dispositif de positionnement (1) selon la revendication 6, **caractérisé en ce qu** 'entre les deux rangées d'aimants (43 à 50) une paroi de séparation (53) en matériau non-magnétique est présent.

8. Dispositif de positionnement (1) selon la revendication 6 ou 7, **caractérisé en ce que** les deux bobines (39, 41) sont reliés de telle sorte que l'amplitude du courant passant à travers chaque bobine est la même.
